# EUROPÄISCHE PATENTSCHRIFT

(11) **EP 2 728 979 B1**
(45) Veröffentlichungstag und Bekanntmachung des Hinweises auf die Patenterteilung: **18.03.2020**
(21) Anmeldenummer: 13190891.5
(22) Anmeldetag: 30.10.2013
(51) Int. Cl.: H05K 1/16, H01F 17/00, H01F 27/28, H01F 41/04, H05K 3/12, H03K 17/95

(54) **Verfahren zur Herstellung einer Spule und elektronisches Gerät**
Method for manufacturing a coil and electronic device
Procédé de fabrication d'une bobine et appareil électronique

(30) Priorität: 02.11.2012 DE 102012220022
(43) Veröffentlichungstag der Anmeldung: 07.05.2014
(73) Patentinhaber: WÜRTH ELEKTRONIK GmbH & Co. KG, D-74676 Niedernhall (DE); Hahn-Schickard-Gesellschaft für angewandte Forschung e.V., 78052 Villingen-Schwenningen (DE)
(72) Erfinder: Kostelnik, Jan, 74592 Kirchberg (DE); Schreivogel, Alina, 71701 Schwieberdingen (DE); Wolf, Jürgen, 74635 Kupferzell (DE); Keck, Jürgen, 70794 Filderstadt (DE); Giousouf, Metin, 73732 Esslingen (DE); Reininger, Thomas, 73249 Wernau/Neckar (DE); Kiessling, Albert, 71263 Weil der Stadt (DE)
(74) Vertreter: Richardt Patentanwälte PartG mbB

(56) Entgegenhaltungen:
- US-A- 4 522 671
- US-A- 5 336 921
- US-A1- 2007 063 807
- US-A1- 2008 252 407
- US-A1- 2008 290 992

## Beschreibung

Die Erfindung betrifft ein Verfahren zur Herstellung einer in einem Substrat integrierten Spule, insbesondere ein Verfahren zur Herstellung einer elektronischen Leiterplatte, sowie ein elektronisches Gerät mit einer solchen elektronischen Leiterplatte.

Aus dem Stand der Technik sind an sich Planarspulen bekannt, bei denen die Spulenwindungen auf die Oberfläche eines Substrats aufgebracht werden. Mit solchen Planarspulen lässt sich kosteneffizient nur eine relativ geringe Induktivität erreichen, wobei die Planarspulen außerdem relativ viel Platz auf der Substratoberfläche einnehmen.

Aus www.elektroniknet.de, 26. April 2012, "Embedding von aktiven und passiven Bauteilen in die Leiterplatte" sind Embedded-Faltflex-Spulen bekannt. Dabei werden flexible Folienstrukturen so gefaltet, dass man Spulen in jeder Größe mit einer nahezu beliebigen Anzahl an Lagen erzeugen kann. Dies ist besonders vorteilhaft für Sensoranwendungen.

Aus DE 43 06 416 A1 ist eine Spulenstruktur für eine Leiterplattenanordnung bekannt. Eine Wicklung der Spule wird durch metallisierte Bohrungen und LeiterbahnAbschnitte gebildet. In einem Schlitz der Leiterplatte kann seitlich ein Ferritkern eingeführt werden. Alternativ kann man direkt die Innenlagen der Leiterplatte als Träger aufgedruckter Kernstrukturen verwenden. Nachteilig bei dieser Spulenstruktur ist, dass diese sich einerseits nicht für die Miniaturisierung eignet und andererseits keine großen Induktivitäten hiermit erzielbar sind.

Aus DE 103 54 694 A1 ist ein induktiver Sensor mit einer Spule zur Erzeugung eines Magnetfelds bekannt. Die Spule wird durch zwei Schichten gebildet, zwischen denen sich als Spulenkern ein Streifen eines amorphen Metalls befindet. Die Spulenwindungen werden durch auf den Schichten angeordnete Leiterbahnabschnitte und Durchgangskontaktierungen gebildet, die an dem Spulenkern vorbei verlaufen.

Aus DE 103 55 003 A1 ist ein induktiver Sensor bekannt, der eine, ein Magnetfeld erzeugende Spule aufweist, deren Spulenkern in einem Durchbruch eines Schaltungsträgers vorgesehen ist.

In der US 2008/0290992 A1 wird ein Halbleiterbauteil mit einer Vielzahl integrierter Spulen offenbart. Dabei überlappen ein erster Teil einer Spule und ein zweiter Teil einer Spule zumindest teilweise.

In der US 2007/0063807 A1 wird eine Vorrichtung und ein Verfahren für eine magnetische Komponente offenbart. Die magnetische Komponente beinhaltet ein Substrat mit einer Struktur und ein erstes leitfähiges Muster, welches auf der Struktur abgeschieden ist. Die magnetische Komponente beinhaltet weiter ein permeables Material, welches in der Struktur abgeschieden ist. Ein Substratmaterial wird auf dem Substrat abgeschieden um im einen Einschluss des permeablen Materials zu erzielen, zwischen dem Substrat und dem Substratmaterial, wobei das Substratmaterial ein zweites leitfähiges Muster aufweist. das erste leitfähige Muster und das zweite leitfähige Muster wirken zusammen um magnetische Eigenschaften des permeablen Materials zu nutzen.
In der US 4,522,671 A wird ein Verfahren vorgeschlagen zur Herstellung elektrisch leitfähiger Muster, bei dem eine elektrisch leitfähige Paste mittels eines elastisch verformbaren Stempels in einem Druckverfahren auf vorgegebene Bereiche eines Trägers aufgebracht wird. Das Verfahren ist erfindungsgemäß verwendbar zum Bedrucken von kleinen Induktivitäten, welche zum Einbau in Hybridschaltungen bestimmt sind.
In der US 2008/0252407 A1 wird vorgeschlagen ein induktives Element für Leistungs-Umwandlungs-Anwendungen zu nutzen. Das induktive Element beinhaltet ein Substrat mit einer ersten Metallschicht auf dem Substrat mit einer Dicke, die größer als ein Micrometer ist, und angeordnet als erster Satz benachbarter, sich nicht schneidender leitfähiger Segmente. Auf der ersten metallischen Schicht befindet sich ein ferromagnetisch ausgelegter Körper, welcher einen ferromagnetischen inneren Kernbereich hat. Zumindest eine weitere metallische Schicht befindet sich auf dem ferromagnetisch ausgelegten Körper und ist als zweiter Satz benachbarter und sich nicht schneidender leitfähiger Segmente angeordnet. Eine Vielzahl leitfähiger Durchkontaktierungen befinden sich in dem ferromagnetisch ausgelegten Körper und sind so angeordnet, dass sie zugehörige Segmente des ersten Satzes aus benachbarten nicht schneidenden leitfähigen Segmenten mit zugehörigen Segmenten des zweiten Satzes aus benachbarten nicht schneidenden leitfähigen Segmenten verbinden, wodurch sie eine angrenzende leitfähige Umwicklung im den inneren Kernbereich darstellen.

Der vorliegenden Erfindung liegt demgegenüber die Aufgabe zugrunde, ein verbessertes Verfahren zum Herstellen einer in einem Substrat integrierten Spule, insbesondere zur Herstellung einer Leiterplatte, sowie ein elektronisches Gerät mit einer solchen Spule zu schaffen.
Die der Erfindung zugrunde liegende Aufgabe wird jeweils mit den Merkmalen der unabhängigen Patentansprüche gelöst. Ausführungsformen der Erfindung sind in den abhängigen Patentansprüchen angegeben.

Nach Ausführungsformen der Erfindung werden zumindest die ersten Windungsabschnitte durch ein 3D-Druckverfahren aufgebracht, insbesondere auch die zweiten Windungsabschnitte und/oder die dritten Windungsabschnitte.

Unter einem "3D-Druckverfahren" wird hier jedes Druckverfahren verstanden, welches eine drucktechnische Aufbringung von dreidimensionalen elektrischen Leitungsstrukturen ermöglicht, wie zum Beispiel Aerosoljet- oder Inkjetdruckverfahren. Bei dem 3D-Druckverfahren wird elektrisch leitfähige Tinte, insbesondere ein elektrisch leitfähiges Polymer, Silberleitpaste oder dergleichen verwendet, um die Leitungsstrukturen drucktechnisch aufzubringen.

Ausführungsformen der Erfindung sind besonders vorteilhaft, da es der Einsatz eines 3D-Druckverfahrens ermöglicht, miniaturisierte Spulen in ein Substrat ein- oder aufzubringen, und dass bei relativ geringen Herstellungskosten und hohem Durchsatz. Hierdurch wird insbesondere die Herstellung von miniaturisierten Spulenarrays einer hohen Auflösung und Empfindlichkeit ermöglicht, insbesondere für die Herstellung von Sensoren, wie zum Beispiel induktiven Näherungssensoren, oder Aktoren.

Nach Ausführungsformen der Erfindung wird zur Herstellung einer Spule beispielsweise wie folgt vorgegangen:
1. Zunächst wird ein Substrat zur Verfügung gestellt. Bei dem Substrat kann es sich um ein Leiterplattenmaterial, insbesondere um faserverstärkten Kunststoff, insbesondere um eine mit Epoxidharz getränkte Glasfasermatte handeln, zum Beispiel ein sogenanntes FR-4-Material.
2. In dem Substrat wird eine Kavität erzeugt, die zum Beispiel zur Vorderseite des Substrats offen ist. Die Erzeugung der Kavität in dem Substrat erfolgt durch eine spanabhebende Bearbeitung, vorzugsweise durch Fräsen sowie auch durch Heißprägen. Die Kavität hat eine Bodenfläche, die beispielsweise parallel zur Oberfläche des Substrats verläuft sowie seitliche Flanken, die die Bodenfläche mit der Oberfläche des Substrats verbinden.
3. Nach der Erzeugung der Kavität werden die ersten und zweiten Windungsabschnitte der Spule in die Kavität eingebracht. Die ersten Windungsabschnitte verlaufen entlang der Flanken der Kavität und erstrecken sich von der Bodenfläche bis zur Oberfläche des Substrats. Die zweiten Windungsabschnitte verlaufen entlang der Bodenfläche und kontaktieren dort jeweils zwei Enden der ersten Windungsabschnitte. Zur Einbringung der ersten und zweiten Windungsabschnitte wird beispielsweise wie folgt vorgegangen werden:
   Die ersten und zweiten Windungsabschnitte werden in einem Arbeitsgang mithilfe des 3D-Druckverfahrens auf die Bodenfläche und die Flanken der Kavität aufgebracht.
4. Die Kavität wird dann mit einem Kernmaterial gefüllt, beispielsweise einer Paste, die ferromagnetische Partikel beinhaltet. Unter einer Paste wird hier eine Mischung einer Partikel und einer Flüssigkeit, beispielsweise eines Lösungsmittels, verstanden, beispielsweise eine Suspension. Durch die eingebrachte Paste wird ein Kernmaterial in der Kavität gebildet, welches zur Realisierung eines Spulenkerns dient. Alternativ kann das Kernmaterial auch in Form eines Festkörpers in die Kavität eingebracht werden, beispielsweise durch Einpressen.
5. Die dritten Windungsabschnitte werden auf die Oberfläche des resultierenden Spulenkerns aufgebracht, und zwar beispielsweise durch eine Strukturierungstechnik, insbesondere Ätzen, oder mit einem Druckverfahren, insbesondere einem 2D Druckverfahren.

Zur Aufbringung einer Spule auf ein Substrat wird hingegen nach nicht erfindungsgemäßen Ausführungsformen beispielsweise wie folgt vorgegangen:
1. Zunächst wird ein Substrat zur Verfügung gestellt. Bei dem Substrat kann es sich um ein Leiterplattenmaterial, insbesondere um faserverstärkten Kunststoff, insbesondere um eine mit Epoxidharz getränkte Glasfasermatte handeln, zum Beispiel ein sogenanntes FR-4-Material.
2. Die zweiten Windungsabschnitte werden auf die Oberfläche des Substrats aufgebracht, beispielsweise durch eine Strukturierungstechnik oder ein zweidimensionales Druckverfahren.
3. Im Bereich der zweiten Windungsabschnitte wird dann Kernmaterial auf die Oberfläche des Substrats aufgebracht, sodass das Kernmaterial die zweiten Windungsabschnitte überdeckt. Die Aufbringung des Kernmaterials kann analog zu dem oben genannten Schritt 4 durch Aufbringung einer Paste, zum Beispiel mit einem Dispenser, oder durch Aufbringung eines Festkörpers erfolgen.
4. Anschließend werden die ersten und dritten Windungsabschnitte der Spule aufgebracht, wobei sich die ersten Windungsabschnitte entlang der seitlichen Flanken des Spulenkerns und die dritten Windungsabschnitte über die Oberfläche des Spulenkerns erstrecken. Hierzu kann beispielsweise nach einer der nachfolgend genannten Ausführungsformen vorgegangen werden:
   a) Die ersten und dritten Windungsabschnitte werden in einem Arbeitsgang mittels eines 3D-Druckverfahrens aufgebracht.
   b) Nur die ersten Windungsabschnitte werden mittels eines 3D-Druckverfahrens aufgebracht, wohingegen die dritten Windungsabschnitte zum Beispiel mittels eines Strukturierungsverfahrens oder zweidimensionalen Druckverfahrens aufgebracht werden.

Auf diese Art und Weise können verschiedene Spulengeometrien realisiert werden, wie zum Beispiel eine Zylinderspule, deren Spulenachse parallel zu der Oberfläche des Substrats verläuft, oder eine ring- bzw. torusförmige Spule, die parallel zu der Oberfläche des Substrats ausgerichtet ist.

Nach einer Ausführungsform der Erfindung ist der Spulenkern in der Kavität ringförmig, torusförmig oder scheibenförmig ausgebildet, wobei der Spulenkern eine runde oder eine eckige Form haben kann. Durch die Wahl anderer Geometrien der Kavität und damit des Spulenkerns kann das von der Spule zu erzeugende Magnetfeld für die jeweilige Anwendung optimiert werden.

Nach einer Ausführungsform der Erfindung hat die Kavität eine zu der Oberfläche des Substrats parallele Bodenfläche. Von der Bodenfläche gehen seitliche Flanken aus, die die Öffnung der Kavität bilden. Die seitlichen Flanken bilden vorzugsweise einen rechten Winkel oder einenspitzen Winkel mit der Oberfläche des Substrats, beispielsweise einen Winkel zwischen 30 und 60°, vorzugsweise 45°.

Ein solcher Winkel hat den überraschenden Vorteil, dass Lufteinschlüsse beim Einbringen der Paste in die Kavität vermieden werden, da die Luft entlang der seitlichen Flanken während des Einbringungsprozesses entweichen kann. Dies ist besonders vorteilhaft, wenn die Paste in die Kavität gedruckt wird, wie zum Beispiel mittels Siebdruck, Tiefdruck, Tampondruck oder mithilfe eines Dispensers.

Als besonders vorteilhaft hat es sich überraschenderweise erwiesen, wenn die Einbringung der Paste mittels Siebdruck erfolgt und die seitlichen Flanken der Kavität einen Winkel von etwa 45° mit der Oberfläche einschließen.

Nach einer Ausführungsform der Erfindung bestehen die Partikel aus einer weichmagnetischen amorphen und/oder nanokristallinen Legierung.

Besonders vorteilhaft sind dabei Partikel, die eine nanokristalline Struktur aufweisen, da dies zu einer sehr hohen Permeabilität bei einer kleinen Koerzitivfeldstärke führt. Weitere Vorteile solcher nanokristallinen Materialien sind überragende Magnetwerte, kostengünstige Legierungszusammensetzungen, eine sehr gute Temperaturstabilität und sehr günstige Frequenzeigenschaften. Die nanokristallinen Partikel können aus einer weichmagnetischen metallischen Legierung, zum Beispiel auf der Basis von Fe, Si und/oder B mit Zusätzen von Nb und/oder Cu, zusammengesetzt sein.

Nach einer Ausführungsform der Erfindung werden mehrere der integrierten Spulen auf diese Art und Weise in dem Substrat hergestellt. Diese Spulen können zum Beispiel zu einem Sensorarray verschaltet werden, zum Beispiel um einen hochempfindlichen induktiven Positionssensor zu realisieren.

Nach einer weiteren Ausführungsform können die zweiten Windungsabschnitte aufgedruckt werden. Die zweiten Windungsabschnitte können zum Beispiel mittels leitfähiger Tinte aufgedruckt werden; weitere Schaltungskomponenten, die polymerelektronisch ausgebildet sein können, können ebenfalls auf das Substrat aufgedruckt werden, um diese mit der oder den Spulen zu verschalten.

Nach einer weiteren Ausführungsform wird die Kavität durch eine Heißprägetechnik hergestellt.

Nach einer Ausführungsform der Erfindung wird unter einer "Kavität" eine Ausnehmung aus dem Substrat oder ein Durchbruch durch zwei oder mehrere übereinander angeordnete Substrate einer mehrschichtigen Leiterplatte, das heißt einer sogenannten Multilayer-PCB verstanden, wobei eines der übereinander angeordneten Substrate die Bodenfläche bildet.

Nach einer Ausführungsform der Erfindung wird der Spulenkern zunächst separat als Festkörper hergestellt, und dann in der Kavität befestigt, zum Beispiel formschlüssig und/oder kraftschlüssig, z.B. durch Einpressen in die Kavität.

Die Spulenkerne können zum Beispiel durch Strangpressen eines Polymer-Ferrit-Kompositmaterials hergestellt werden. Beispielsweise werden durch das Strangpressen Endlosprofile aus dem Polymer-Ferrit-Kompositmaterial hergestellt, von denen einzelne Spulenkerne durch Abtrennen von Abschnitten des Strangpressprofils gewonnen werden.

Ein solcher Strang kann auch als flexibles Band hergestellt werden, und mit einem Kleber auf das Substrat aufgebracht werden, und zwar insbesondere dort, wo eine höhere Baudicke toleriert werden kann. In diesem Fall kann sich also der Spulenkern auch über die Oberfläche des Substrats hinaus erstrecken, wobei auch Mischformen möglich sind, beispielsweise also die Füllung der Kavität in dem Substrat mit einem pastösen oder flüssigen Material und anschließend nach Aushärtung die Aufbringung einer oder mehrerer Materialschichten desselben oder eines anderen Kernmaterials auf die bereits gefüllte Kavität. Eine solche zusätzliche Folie könnte auch auf eine Seite einer Leiterplatte, insbesondere einer Multilayer-PCB aufgeklebt werden, was insbesondere dann vorteilhaft ist, wenn der Sensor an der Stirnfläche angeordnet sein soll.

Nach einer Ausführungsform der Erfindung kann der Querschnitt einer Kavität bzw. des Spulenkerns unterschiedliche geometrische Formen haben, die symmetrisch oder asymmetrisch sein können. Die Form der Kavität und damit die Form des Spulenkerns kann dabei so gewählt werden, dass das Magnetfeld eine für die jeweilige Anwendung optimierte Geometrie und Stärke erhält.

Neben einer Rechteckform kann der Spulenkern zum Beispiel dreieckig, rund oder ballig ausgebildet sein. Solche geometrische Formen der Kavität können zum Beispiel durch Ausfräsen oder durch Wasserstrahlschneiden hergestellt werden und die Füllung der Kavität mit dem Kernmaterial kann zum Beispiel durch Drucken, insbesondere durch Inkjet, erreicht werden.

Ferner ist es auch möglich, dass innerhalb des Spulenkerns das Kernmaterial örtlich variiert wird, um eine gewünschte Form des Magnetfelds zu erreichen, wobei eine solche örtliche Variation der Materialzusammensetzung in dem Spulenkern zum Beispiel durch schichtweises Aufdrucken unterschiedlicher Kernmaterialien erreicht werden kann.

Nach einer Ausführungsform der Erfindung erstreckt sich die Kavität über mehrere Substratschichten in vertikaler Richtung, wobei die Vias, das heißt die Durchgangskontaktierungen, zum Beispiel durch Bohren, Lasern, Plasmieren oder Wasserstrahlschneiden hergestellt werden können. Auch Kombinationen solcher Techniken sind möglich, wie z.B. Wasserstrahlschneiden mit Laserführung.

Ausführungsformen der Erfindung erlauben die Herstellung von miniaturisierten Spulen mithilfe von preiswerten hochdurchsatzfähigen Strukturierungs- und Produktionstechnologien, wie sie für die Massenproduktion geeignet sind.

Nach der Erfindung beinhaltet das Substrat Glasfasern, die in dem Substrat entlang einer oder mehreren Vorzugsrichtungen, beispielsweise in Form einer Glasfasermatrix, oder ungeordnet vorhanden sind; insbesondere kann es sich bei dem Substrat um ein glasfaserverstärktes Leiterplattenmaterial handeln.

In diesem Fall werden Glasfasern aufgrund der Einbringung der Kavität in das Substrat durchtrennt, sodass die Kavität eine entsprechend raue Oberflächenbeschaffenheit hat. Zur Glättung der Oberfläche der Kavität wird vor der Einbringung der ersten und zweiten Windungsabschnitte ein Material in die Kavität eingebracht, welches sich über die Flanken und die Bodenfläche der Kavität erstreckt. Beispielsweise wird die Kavität vollständig mit dem Material gefüllt. Bei dem Material kann es sich um einen Kunststoff, ein Harz oder einen anderen Isolator handeln.

Dieses Material wird dann teilweise wieder aus der Kavität entfernt, zum Beispiel durch eine spanabhebende Bearbeitung oder durch Beaufschlagung mit einem Laserstrahl. Eine Schicht des Materials, die sich über die Flanken und die Bodenfläche erstreckt, verbleibt in der Kavität.

Da das Material keine Glasfasern beinhaltet, hat es eine entsprechend glatte Oberfläche, das heißt die Rauheit der Oberfläche dieser Materialschicht ist geringer als die Rauheit der Flanken und der Bodenfläche der Kavität. Beispielsweise kann die Schichtdicke dieser Materialschicht weniger als 30 µm, insbesondere zwischen 10 µm und 20 µm betragen.

Auf diese Materialschicht werden dann die ersten und zweiten Windungsabschnitte aufgebracht. Überraschenderweise hat die resultierende Spule dann eine verbesserte Spulengüte.

Dies ist dadurch zu erklären, dass bei Aufbringung der ersten und zweiten Windungsabschnitte unmittelbar auf die Flanken bzw. die Bodenfläche durch das 3D-Druckverfahren die aufgedruckten Windungsabschnitte einen reduzierten effektiven Leitungsquerschnitt haben, der durch die Rauheit der Oberfläche bedingt ist. Dieser reduzierte effektive Leitungsquerschnitt führt zu einer Vergrößerung des ohmschen Widerstandes und damit zu einer Verringerung der Spulengüte.

Nach Ausführungsformen der Erfindung wird dieses Problem dadurch behoben, dass die Flanken und die Bodenfläche der Kavität durch Aufbringung der Materialschicht geglättet werden, und dass die ersten und zweiten Windungsabschnitte nicht unmittelbar auf die Flanken und die Bodenfläche, sondern auf die Materialschicht, die sich über die Flanken und die Bodenfläche erstreckt, aufgebracht werden.

Im Weiteren werden Ausführungsformen der Erfindung mit Bezugnahme auf die Zeichnungen näher erläutert.

Es zeigen:
- Figur 1: einen schematischen Querschnitt einer erfindungsgemäßen elektronischen Leiterplatte mit einer integrierten Spule,
- Figur 2: eine perspektivische Ansicht der Leiterplatte gemäß Figur 1,
- Figur 3: einen schematischen Querschnitt einer Ausführungsform einer nicht erfindungsgemäßen Leiterplatte mit einer aufgebrachten Spule,
- Figur 4: eine perspektivische Ansicht der Leiterplatte gemäß Figur 3,
- Figur 5: eine Kavität mit aufgebrachten ersten und zweiten Windungsabschnitten,
- Figur 6: eine vergrößerte Teildarstellung der Figur 5, die einen Abschnitt der Bodenfläche und einer Flanke der Kavität zeigt,
- Figuren 7 - 13: eine Ausführungsform eines Verfahrens zur Herstellung einer elektronischen Leiterplatte mit einer integrierten torus- oder ringförmigen Spule.
- Figur 14: eine Draufsicht auf eine Ausführungsform einer erfindungsgemäßen Leiterplatte mit einer integrierten Ringspule,
- Figur 15: eine Draufsicht auf eine Ausführungsform einer erfindungsgemäßen Leiterplatte mit einer integrierten ovalen Spule.

Elemente der nachfolgenden Ausführungsbeispiele, die einander entsprechen oder identisch sind, werden jeweils mit denselben Bezugszeichen gekennzeichnet.

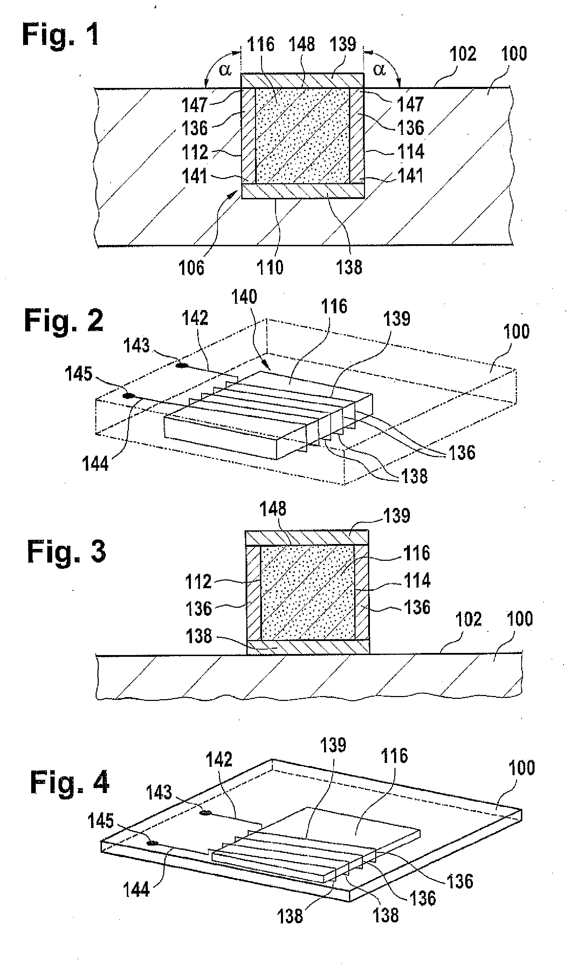

Figur 1 zeigt ein Substrat 100, bei dem es sich um ein Leiterplattenmaterial, beispielsweise mit einer Glasfaserverstärkung handeln kann. Zur Integration einer Spule 140 (vgl. Fig. 2) in das Substrat 100 wird zunächst eine Kavität 106 in dem Substrat 100 hergestellt, wodurch eine Oberfläche 102 des Substrats 100 geöffnet wird.

Beispielsweise wird die Kavität 106 in dem Substrat 100 durch eine spanabhebende Bearbeitung hergestellt, indem die Kavität 106 in das Substrat 100 eingefräst wird. Hierdurch entsteht eine Bodenfläche 110 der Kavität 106, welche beispielsweise parallel zu der Oberfläche 102 verläuft. Ferner entstehen hierdurch seitliche Flanken 112 und 114 der Kavität 106, die jeweils einen Winkel α mit der Oberfläche 102 einschließen. Bei dem Winkel α kann es sich um einen rechten Winkel (wie in der Fig. 1 gezeigt) oder um einen spitzen Winkel handeln, insbesondere einen Winkel von weniger als 50°, beispielsweise 45°.

Im nächsten Schritt werden die ersten Windungsabschnitte 136 auf die Flanken 112 und 114 sowie die zweiten Windungsabschnitte 138 auf die Bodenfläche 110 der Kavität 106 aufgebracht.

Dies kann so erfolgen, dass die ersten Windungsabschnitte 136 und die zweiten Windungsabschnitte 138 in einem Arbeitsgang durch ein 3D-Druckverfahren, insbesondere durch Aerosoljet oder Inkjet, aufgebracht werden. Dies kann in Form eines leitfähigen Polymers erfolgen.

Anschließend wird die Kavität 106 mit einem Kernmaterial zur Bildung des Spulenkerns gefüllt, wie zum Beispiel mit einer Paste 116, die ferromagnetische Partikel beinhaltet. Nach Aushärtung der Paste 116 werden dritte Windungsabschnitte 139 auf die obere Seite 148 des durch die ausgehärtete Paste gebildeten Spulenkerns aufgebracht, wie zum Beispiel durch eine Strukturierungstechnik oder ein zweidimensionales Druckverfahren.

Die ersten Windungsabschnitte 136 haben jeweils ein unteres erstes Ende 141 und ein oberes zweites Ende 147. Durch einen der zweiten Windungsabschnitte 138 werden je zwei der ersten Enden 141 von zwei der ersten Windungsabschnitte 136 elektrisch verbunden, wohingegen durch die dritten Windungsabschnitte 139 jeweils zwei der zweiten Enden 147 zweier verschiedener erster Windungsabschnitte 136 elektrisch kontaktiert werden, sodass im Ergebnis eine in etwa helixförmige Spulenwicklung zur Bildung der Spule 140 resultiert.

Die Einbringung der Paste 116 in die Kavität 106 kann ebenfalls drucktechnisch erfolgen. Besonders vorteilhaft ist eine Wahl des Winkels α von 45°, wenn die Paste 116 mittels Siebdruck eingebracht wird, da dann die Bildung von Lufteinschlüssen in der Paste 116 besonders effizient verhindert wird. Ferner kann die Paste 116 während des Aushärtens mit Ultraschall oder anderen Vibrationen beaufschlagt werden, um eine Pfropfenbildung während des Aushärtens der Paste 116 zu verhindern. Alternativ kann der Spulenkern anstatt durch die Paste 116 durch einen Festkörper gebildet werden, der in die Kavität 106 eingebracht wird.

Die Figur 2 zeigt eine perspektivische Ansicht der resultierenden Leiterplatte 100 mit der integrierten Spule 140.

Die Figur 3 zeigt eine alternative Ausführungsform, bei der die Spule 140 auf dem Substrat 100 aufgebracht wird. Hierzu werden zunächst die zweiten Windungsabschnitte 138 auf das Substrat 100 aufgebracht. Auf die zweiten Windungsabschnitte 138 wird dann das Kernmaterial, beispielsweise in Form der Paste 116 oder als Festkörper, aufgebracht, wobei das Kernmaterial die zweiten Windungsabschnitte 138 zumindest teilweise überdeckt, beispielsweise bis auf Randbereiche der zweiten Windungsabschnitte 138, wie in der Figur 3 gezeigt.

Nach Ausbildung des Spulenkerns, das heißt beispielsweise nach Aushärtung der Paste 116, werden dann die ersten Windungsabschnitte 136 auf die Flanken 112 bzw. 114 des resultierenden Spulenkerns aufgebracht und die dritten Windungsabschnitte 139 werden auf die obere Seite 148 aufgebracht. Die resultierende Leiterplatte 110 mit der aufgebrachten Spule 100 zeigt die Figur 4 in perspektivischer Ansicht.

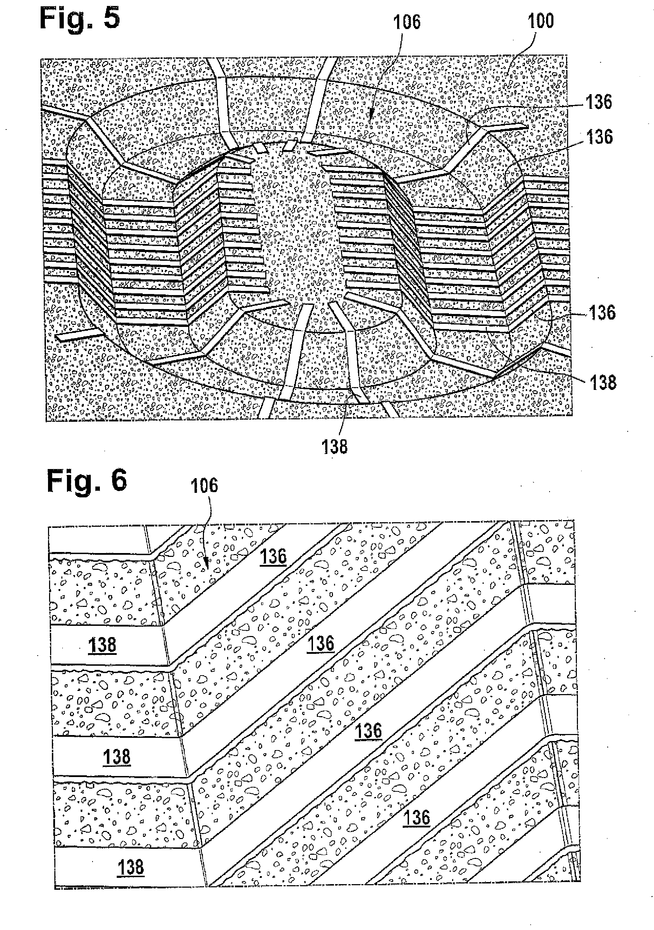

Die Figur 5 zeigt eine Ausführungsform der Erfindung, bei der eine ovale Ringspule in das Substrat 100 integriert werden soll. Hierzu wird eine ovale Kavität 106 in das Substrat 100 eingefräst, wobei das Substrat 100 glasfaserverstärkt ist. Die Figur 5 zeigt ein Zwischenprodukt bei der Integration der Spule 140 in das Substrat 100, nachdem die ersten und zweiten Windungsabschnitte 136 bzw. 138 mit einem 3D-Druckverfahren aufgedruckt worden sind.

Die Figur 6 zeigt eine Teilansicht der Figur 5 in fünffacher Vergrößerung, wobei die raue Oberfläche der Kavität 106 und die resultierende unregelmäßige Struktur der ersten und zweiten Windungsabschnitte 136 bzw. 138 ersichtlich ist.

Die raue Oberfläche der Kavität 106 ist durch Glasfasern des Substrats 100 bedingt, die beim Einfräsen der Kavität 106 durchtrennt werden. Die resultierende unregelmäßige Strukturierung der Windungsabschnitte 136 und 138 führt zu einer Reduzierung von deren effektiven Querschnittsfläche, und damit zu einer Erhöhung des ohmschen Widerstands, was schließlich zu einer Reduzierung der Spulengüte der herzustellenden Spule 140 führt.

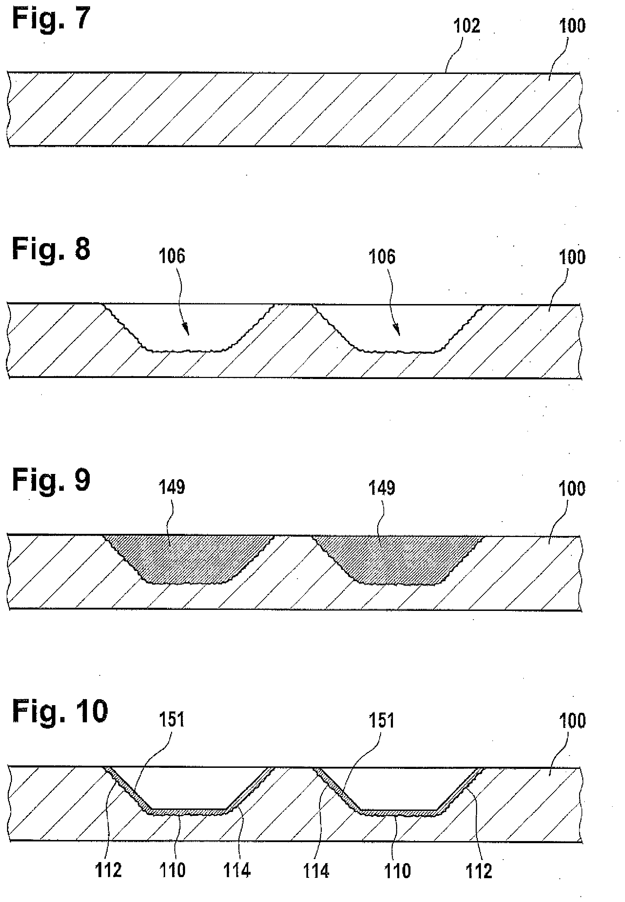

Zur Behebung dieses Problems, welches bei einem Substrat 100 mit einem Glasfaseranteil auftreten kann, kann gemäß der Ausführungsform nach Figuren 7 bis 13 vorgegangen werden:
Zunächst wird das Substrat 100 zur Verfügung gestellt, welches glasfaserverstärkt ist, wie in der Figur 7 dargestellt. In das Substrat 100 wird dann die Kavität 106 eingefräst, wobei Glasfasern bei dem Ausfräsen durchtrennt werden, was zu einer hohen Oberflächenrauigkeit der resultierenden Kavität 106 führt (Figur 8).

Die Kavität 106 wird dann mit einem Material 149 gefüllt. Bei diesem Material 149 kann es sich zum Beispie! um ein Harz handeln. Dies ist in der Figur 9 dargestellt.

Das Material 149 wird dann aus der Kavität 106 bis auf eine Schicht 151 entfernt, beispielsweise ebenfalls durch Ausfräsen. Die auf der Oberfläche der Kavität 106 verbleibende Schicht 151 des Materials 149 kann eine Dicke von zum Beispiel 10 µm bis 20 µm haben (vergleiche Figur 10).

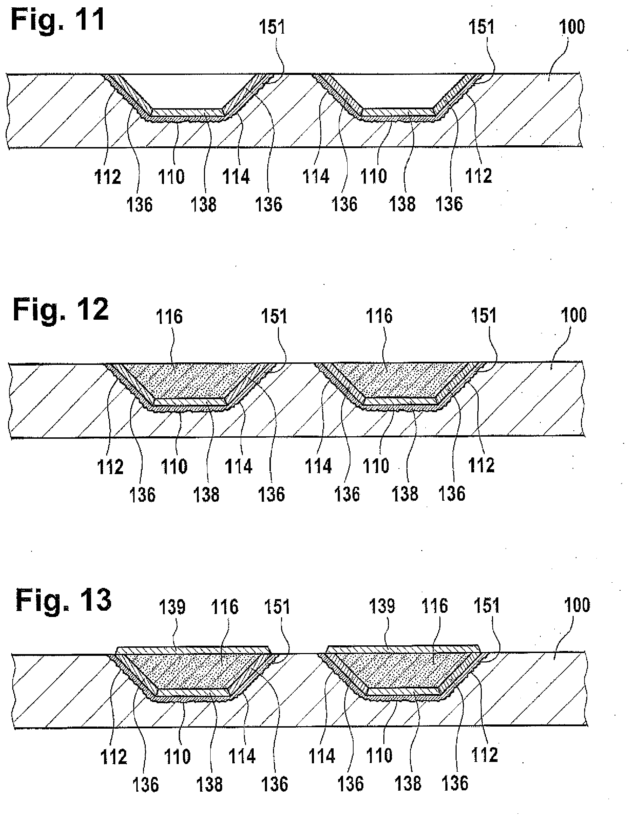

In den nachfolgend in den Figuren 11, 12 und 13 dargestellten Verfahrensschritten wird dann die eigentliche Spule 140 hergestellt, indem zunächst die ersten und zweiten Windungsabschnitte auf die Flanken 112 und 114 der mit der Schicht 151 beschichteten Kavität 106 bzw. auf die mit der Schicht 151 beschichtete Bodenfläche 110 aufgebracht werden (Figur 11). Anschließend wird das Kernmaterial zur Bildung des Spulenkerns in die Kavität 106 eingebracht, zum Beispiel durch Dispensieren der Paste 116 in die Kavität 106, um die Kavität 106 mit der Paste 116 zu füllen (Figur 12).

Schließlich werden die dritten Windungsabschnitte 139 auf den so gebildeten Spulenkern aufgebracht.

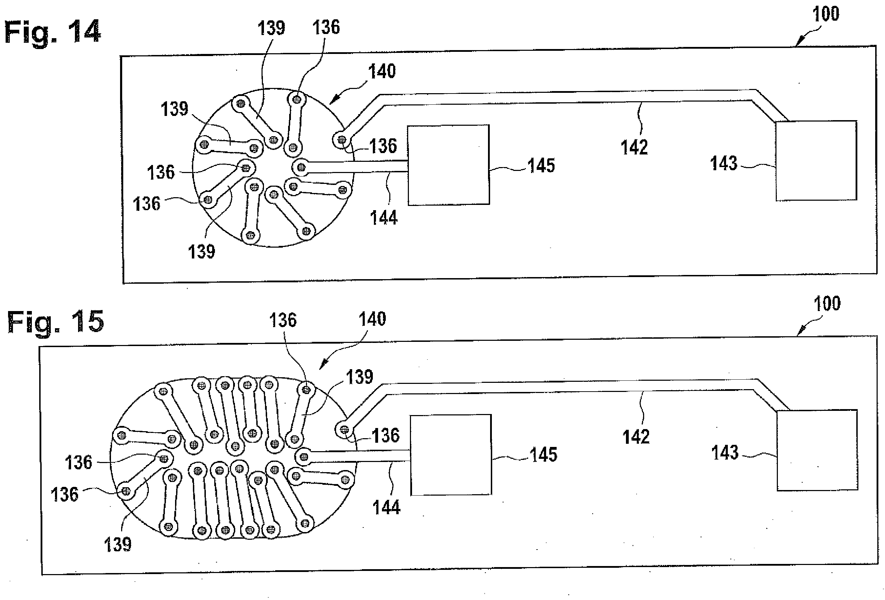

Die Figur 14 zeigt eine Draufsicht auf die Oberfläche 102 des Substrats 100 mit den in dieser Ebene verlaufenden dritten Windungsabschnitten 139, die jeweils zwei zweite Enden 147 der zweiten Windungsabschnitte 136 miteinander elektrisch verbinden, wobei die Spule 140 hier als Ringspule ausgebildet ist.

Die ersten und letzten Windungsabschnitte 139 der Spule 140 sind hier über Leiterbahnen 142 bzw. 144 mit Kontaktflächen 143 bzw. 145 verbunden.

Der Durchmesser der Spule 140 kann kleiner als 5 mm sein, wie zum Beispiel 3,5 mm.

Die Figur 15 zeigt eine entsprechende Spule 140 in einer ovalen Ausführungsform entsprechend der Ausführungsform gemäß Figuren 5 bis 13.

### Bezugszeichenliste

- 100: Substrat
- 102: Oberfläche
- 106: Kavität
- 110: Bodenfläche
- 112: Flanke
- 114: Flanke
- 116: Paste
- 136: erster Windungsabschnitt
- 138: zweiter Windungsabschnitt
- 139: dritter Windungsabschnitt
- 140: Spule
- 141: erstes Ende
- 142: Leiterbahn
- 143: Kontaktfläche
- 144: Leiterbahn
- 145: Kontaktfläche
- 147: zweites Ende
- 148: obere Seite
- 149: Material
- 151: Schicht

## Patentansprüche

1. Verfahren zur Herstellung einer in einem Substrat (100) integrierten Spule (140), wobei die Spule erste Windungsabschnitte (136) aufweist, die jeweils erste (141) und zweite (147) Enden haben, und wobei die Spule zweite (138) und dritte (139) Windungsabschnitte aufweist, wobei durch die zweiten Windungsabschnitte (138) jeweils zwei der ersten Enden und durch die dritten Windungsabschnitte (139) jeweils zwei der zweiten Enden der ersten Windungsabschnitte (136) elektrisch miteinander verbunden werden, so dass hierdurch Spulenwindungen der Spule gebildet werden, wobei zumindest die ersten Windungsabschnitte (136) durch ein 3D-Druckverfahren, welches eine drucktechnische Aufbringung von dreidimensionalen elektrischen Leitungsstrukturen ermöglicht, aufgebracht werden, wobei eine Kavität (106) in dem Substrat erzeugt wird, wobei die ersten Windungsabschnitte (136) auf die Flanken (112, 114) der Kavität und die zweiten Windungsabschnitte (138) auf den Boden (110) der Kavität durch das 3D-Druckverfahren aufgedruckt werden, wobei das Substrat Glasfasern beinhaltet und die Kavität in dem Substrat durch ein spanabhebendes Verarbeitungsverfahren erzeugt wird, sodass die Glasfasern des Substrats, die sich in einem Randbereich der Kavität befinden, durch das spanabhebende Bearbeitungsverfahren bei der Erzeugung der Kavität durchtrennt werden, mit folgenden weiteren Schritten:
- Einbringung eines Materials (149) in die Kavität, wobei sich das Material zumindest über den Boden und die Flanken der Kavität erstreckt,
- teilweise Entfernung des Materials (149) aus der Kavität bis auf eine Schicht (151) des Materials, die sich über den Boden und die Flanken der Kavität erstreckt, wobei die ersten Windungsabschnitte und die zweiten Windungsabschnitte auf die Schicht des Materials aufgebracht werden.

2. Verfahren nach Anspruch 1, wobei es sich bei dem 3D-Druckverfahren um Aerosoljet oder Inkjet handelt.

3. Verfahren nach Anspruch 1 oder 2, wobei die ersten Windungsabschnitte und die zweiten Windungsabschnitte in einem einzigen Druckvorgang des 3D-Druckverfahrens aufgebracht werden.

4. Verfahren nach einem der vorhergehenden Ansprüche, wobei nach der Einbringung der ersten und zweiten Windungsabschnitte ein Kernmaterial (116) in die Kavität eingebracht wird, und auf das Kernmaterial die dritten Windungsabschnitte aufgebracht werden.

5. Verfahren nach einem der vorhergehenden Ansprüche, wobei es sich bei dem Material um ein Harz oder einen Kunststoff handelt.

6. Verfahren nach Anspruch 4, wobei das Kernmaterial in Form einer Paste (116) oder eines Festkörpers in die Kavität eingebracht wird.

7. Verfahren nach einem der vorhergehenden Ansprüche, wobei es sich bei dem Substrat um ein Leiterplattenmaterial einer elektronischen Leiterplatte handelt.

8. Verfahren nach Anspruch 7, wobei es sich bei dem Leiterplattenmaterial um faserverstärkten Kunststoff handelt.

9. Verfahren nach einem der vorhergehenden Ansprüche, wobei die seitlichen Flanken der Kavität jeweils einen rechten oder einen spitzen Winkel mit dem Boden (110) der Kavität einschließen.

10. Verfahren nach Anspruch 9, wobei der Winkel zwischen 30° und 60° beträgt.

11. Verfahren nach einem der Ansprüche 4 oder 6, wobei das Kernmaterial ferromagnetsiche Partikel und/oder ein Ferrit beinhaltet.

12. Verfahren nach Anspruch 11, wobei es sich bei den Partikeln um Partikel aus einer weichmagnetischen amorphen und/oder nanokristallinen Legierung handelt.

13. Verfahren nach einem der Ansprüche 4, 6, 11 oder 12, wobei das Kernmaterial in Form einer Paste (116) in die Kavität gedruckt oder mit einem Dispenser aufgetragen wird.

14. Verfahren nach einem der vorhergehenden Ansprüche, wobei die Kavität seitliche Flanken hat, die mit der Oberfläche jeweils einen Winkel von 40° bis 50°, einschließen, und wobei die Einbringung der Paste in die Kavität mittels Siebdruck erfolgt.

15. Verfahren nach einem der vorhergehenden Ansprüche, wobei die Aufbringung der zweiten Windungsabschnitte (138) mittels einer Strukturierungstechnik erfolgt.

16. Verfahren nach einem der vorhergehenden Ansprüche, wobei mehrere der Spulen in dem Substrat hergestellt werden, und die Spulen zu einem Sensorarray verschaltet werden.

17. Verfahren nach einem der vorhergehenden Ansprüche, wobei die Kavität vollständig mit der Paste gefüllt wird.

18. Verfahren nach einem der vorhergehenden Ansprüche, wobei die Paste während eines Trocknungsprozesses der Paste zur Aushärtung der Paste durchmischt wird.

19. Verfahren nach Anspruch 18, wobei die Durchmischung durch Rütteln oder durch Beaufschlagung mit Ultraschall erfolgt.

20. Elektronisches Gerät mit einer elektronischen Leiterplatte und mit zumindest einer in der Leiterplatte integrierten Spule (140), wobei die Spule erste Windungsabschnitte aufweist, die jeweils erste und zweite Enden haben, und wobei die Spule zweite und dritte Windungsabschnitte aufweist, wobei durch die zweiten Windungsabschnitte jeweils zwei der ersten Enden und durch die dritten Windungsabschnitte jeweils zwei der zweiten Enden der ersten Windungsabschnitte elektrisch miteinander verbunden sind, so dass hierdurch Spulenwindungen der Spule gebildet sind, wobei zumindest die ersten Windungsabschnitte durch ein 3D-Druckverfahren, welches eine drucktechnische Aufbringung von dreidimensionalen elektrischen Leitungsstrukturen ermöglicht, aufgebracht sind, wobei eine Kavität (106) in dem Substrat erzeugt ist, wobei die ersten Windungsabschnitte (136) auf die Flanken (112, 114) der Kavität und die zweiten Windungsabschnitte (138) auf den Boden (110) der Kavität durch das 3D-Druckverfahren aufgedruckt sind, wobei das Substrat Glasfasern beinhaltet und die Kavität in dem Substrat durch ein spanabhebendes Verarbeitungsverfahren erzeugt ist, sodass die Glasfasern des Substrats, die sich in einem Randbereich der Kavität befinden, durch das spanabhebende Bearbeitungsverfahren bei der Erzeugung der Kavität durchtrennt sind, wobei ein Material (149) in die Kavität eingebracht ist, wobei sich das Material zumindest über den Boden und die Flanken der Kavität erstreckt, und wobei das Material (149) zumindest teilweise aus der Kavität entfernt ist, bis auf eine Schicht (151) des Materials, die sich über den Boden und die Flanken der Kavität erstreckt, wobei die ersten Windungsabschnitte und die zweiten Windungsabschnitte auf die Schicht des Materials aufgebracht sind.

21. Elektronisches Gerät nach Anspruch 20, wobei es sich um einen Sensor und/oder um einen Aktor handelt.

22. Elektronisches Gerät nach Anspruch 21, wobei es sich bei dem Sensor um einen Druck-, Kraft-, Beschleunigungs- oder Magnetfeldsensor handelt.

## Claims

1. A method for producing a coil (140) integrated in a substrate (100), wherein the coil has first winding portions (136), which each have a first end (141) and a second end (147), and wherein the coil has second winding portions (138) and third winding portions (139), wherein the second winding portions (138) electrically interconnect two of the first ends of the first winding portions (136) each, and the third winding portions (139) electrically interconnect two of the second ends of the first winding portions (136) each, such that coil windings of the coil are thus formed, wherein at least the first winding portions (136) are applied by a 3D printing method which enables three-dimensional electrical line structures to be applied by printing, wherein a cavity (106) is produced in the substrate, wherein the first winding portions (136) are applied to the flanks (112, 114) of the cavity and the second winding portions (138) are applied to the base (110) of the cavity by the 3D printing method, wherein the substrate contains glass fibres and the cavity is produced in the substrate by means of a machining method, such that the glass fibres of the substrate located in an edge region of the cavity are severed by the machining method when producing the cavity, the method comprising the following further steps:
- introducing a material (149) into the cavity, wherein the material extends at least over the base and the flanks of the cavity,
- partially removing the material (149) from the cavity apart from a layer (151) of the material extending over the base and the flanks of the cavity, wherein the first winding portions and the second winding portions are applied to the layer of material.

2. The method according to claim 1, wherein the 3D printing method is aerosol jet printing or inkjet printing.

3. The method according to claim 1 or 2, wherein the first winding portions and the second winding portions are applied in a single printing process of the 3D printing method.

4. The method according to any one of the preceding claims, wherein, once the first and second winding portions have been introduced, a core material (116) is introduced into the cavity and the third winding portions are applied to the core material.

5. The method according to any one of the preceding claims, wherein the material is a resin or a plastic.

6. The method according to claim 4, wherein the core material is introduced into the cavity in the form of a paste (116) or a solid.

7. The method according to any one of the preceding claims, wherein the substrate is a printed circuit board material of an electronic printed circuit board.

8. The method according to claim 7, wherein the printed circuit board material is a fibre-reinforced plastic.

9. The method according to any one of the preceding claims, wherein the side flanks of the cavity each enclose a right angle or an acute angle with the base (110) of the cavity.

10. The method according to claim 9, wherein the angle is between 30° and 60°.

11. The method according to either one of claims 4 or 6, wherein the core material contains ferromagnetic particles and/or a ferrite.

12. The method according to claim 11, wherein the particles are particles of a soft magnetic amorphous and/or nanocrystalline alloy.

13. The method according to any one of claims 4, 6, 11 or 12, wherein the core material is pressed into the cavity in the form of a paste (116) or is applied using a dispenser.

14. The method according to any one of the preceding claims, wherein the cavity has side flanks, which each enclose an angle of from 40° to 50° with the surface, and wherein the paste is introduced into the cavity by means of screen printing.

15. The method according to any one of the preceding claims, wherein the second winding portions (138) are applied by means of a structuring technique.

16. The method according to any one of the preceding claims, wherein a plurality of the coils are produced in the substrate, and the coils are connected to form a sensor array.

17. The method according to any one of the preceding claims, wherein the cavity is filled completely with the paste.

18. The method according to one of the preceding claims, wherein the paste is mixed during a drying process of the paste in order to cure the paste.

19. The method according to claim 18, wherein the mixing is performed by means of shaking or by application of ultrasound.

20. An electronic device comprising an electronic printed circuit board and comprising at least one coil (140) integrated in the printed circuit board, wherein the coil has first winding portions, which each have a first end and a second end, and wherein the coil has second winding portions and third winding portions, wherein the second winding portions electrically interconnect two of the first ends of the first winding portions each, and the third winding portions electrically interconnect two of the second ends of the first winding portions each, such that coil windings of the coil are formed hereby, wherein at least the first winding portions are applied by means of a 3D printing method, which enables three-dimensional electrical line structures to be applied by printing, wherein a cavity (106) is produced in the substrate, wherein the first winding portions (136) are printed onto the flanks (112, 114) of the cavity and the second winding portions (138) are printed onto the base (110) of the cavity by the 3D printing method, wherein the substrate contains glass fibres and the cavity is produced in the substrate by means of a machining method, such that the glass fibres of the substrate located in an edge region of the cavity are severed by the machining method when producing the cavity, wherein a material (149) is introduced into the cavity, wherein the material extends at least over the base and the flanks of the cavity, and wherein the material (149) is removed at least in part from the cavity apart from a layer (151) of the material that extends over the base and the flanks of the cavity, wherein the first winding portions and the second winding portions are applied to the layer of material.

21. The electronic device according to claim 20, wherein said device is a sensor and/or an actuator.

22. The electronic device according to claim 21, wherein the sensor is a pressure, force, acceleration or magnetic field sensor.

## Revendications

1. Procédé de fabrication d'une bobine (140) intégrée dans un substrat (100), dans lequel la bobine présente des premiers segments d'enroulements (136) qui ont respectivement des premières (141) et des deuxièmes extrémités (147), et dans lequel la bobine présente des deuxièmes (138) et des troisièmes (139) segments d'enroulements, où, respectivement deux des premières extrémités sont reliées l'une à l'autre électriquement par les deuxièmes segments d'enroulements (138, et respectivement deux des deuxièmes extrémités des premiers segments d'enroulements (136) sont reliées l'une à l'autre électriquement par les troisièmes segments d'enroulements (139), de sorte qu'ainsi des enroulements de bobine de la bobine sont formés, où au moins les premiers segments d'enroulements (136) sont rapportés par un procédé d'impression en 3D, lequel permet un apport par une technique d'impression de structures conductrices électriques tridimensionnelles, où une cavité (106) est créée dans le substrat, où les premiers segments d'enroulements (136) sont imprimés sur les flancs (112, 114) de la cavité et les deuxièmes segments d'enroulements (138) sont imprimés sur le fond (110) de la cavité par le procédé d'impression en 3D, où le substrat contient des fibres de verre et la cavité est créée dans le substrat par un procédé de traitement par abrasion de copeaux, de sorte que les fibres de verre du substrat qui se trouvent au niveau d'une zone de bordure de la cavité sont sectionnées par le procédé de traitement par abrasion de copeaux lors de la création de la cavité, avec les autres étapes suivantes :
- l'apport d'un matériau (149) dans la cavité, où le matériau s'étend au moins sur le fond et les flancs de la cavité,
- le retrait partiel du matériau (149) de la cavité jusqu'à ce qu'il ne reste qu'une couche (151) du matériau qui s'étend par-dessus le fond et les flancs de la cavité, où les premiers segments d'enroulements et les deuxièmes segments d'enroulements sont rapportés sur la couche de matériau.

2. Procédé selon la revendication 1, dans lequel il s'agit d'un jet d'aérosol ou d'un jet d'encre dans le cas du procédé d'impression en 3D.

3. Procédé selon la revendication 1 ou la revendication 2, dans lequel les premiers segments d'enroulements et les deuxièmes segments d'enroulements sont appliqués en un seul processus d'impression du procédé d'impression en 3D.

4. Procédé selon l'une des revendications précédentes, dans lequel, après l'application des premiers et des deuxièmes segments d'enroulements, un matériau de cœur (116) est appliqué dans la cavité et les troisièmes segments d'enroulements sont appliqués sur le matériau de cœur.

5. Procédé selon l'une des revendications précédentes, dans lequel, dans le cas du matériau, il s'agit d'une résine ou d'une matière plastique.

6. Procédé selon la revendication 4, dans lequel le matériau de cœur est appliqué dans la cavité sous la forme d'une pâte (116) ou d'un corps solide.

7. Procédé selon l'une des revendications précédentes, dans lequel, dans le cas du substrat, il s'agit d'un matériau de circuit imprimé d'un circuit imprimé électronique.

8. Procédé selon la revendication 7, dans lequel, dans le cas du matériau de circuit imprimé, il s'agit d'une matière plastique renforcée de fibres.

9. Procédé selon l'une des revendications précédentes, dans lequel les flancs latéraux de la cavité font respectivement un angle droit ou un angle aigu avec le fond (110) de la cavité.

10. Procédé selon la revendication 9, dans lequel l'angle est entre 30 ° et 60 °.

11. Procédé selon l'une des revendications 4 ou 6, dans lequel le matériau de cœur contient des particules ferromagnétiques et/ou un ferrite.

12. Procédé selon la revendication 11, dans lequel, dans le cas des particules, il s'agit de particules à base d'un alliage amorphe magnétique doux et/ou nanocristallin.

13. Procédé selon l'une des revendications 4, 6, 11 ou 12, dans lequel le matériau de cœur est pressé dans la cavité sous forme d'une pâte (116) ou est appliqué avec un système de distribution.

14. Procédé selon l'une des revendications précédentes, dans lequel la cavité a des flancs latéraux qui font respectivement un angle avec la surface de 40 ° à 50 °, et où l'application de la pâte dans la cavité a lieu au moyen d'une sérigraphie.

15. Procédé selon l'une des revendications précédentes, dans lequel l'application des deuxièmes segments d'enroulements (138) a lieu au moyen d'une technique de structuration.

16. Procédé selon l'une des revendications précédentes, dans lequel plusieurs parmi les bobines sont fabriquées dans le substrat, et les bobines sont placées dans un circuit pour faire un circuit de capteur.

17. Procédé selon l'une des revendications précédentes, dans lequel la cavité est totalement remplie avec la pâte.

18. Procédé selon l'une des revendications précédentes, dans lequel la pâte est mélangée pendant un processus de séchage de la pâte pour le durcissement de la pâte.

19. Procédé selon la revendication 18, dans lequel le mélange a lieu par des secousses ou par l'application d'ultrasons.

20. Appareil électronique avec un circuit imprimé électronique et avec au moins une bobine (140) intégrée dans le circuit électronique, où la bobine présente des premiers segments d'enroulements qui ont respectivement des premières et des deuxièmes extrémités, et où la bobine présente des deuxièmes et des troisièmes segments d'enroulements, où, respectivement deux des premières extrémités sont reliées l'une à l'autre électriquement par les deuxièmes segments d'enroulements, et respectivement deux des deuxièmes extrémités des premiers segments d'enroulements sont reliées l'une à l'autre électriquement par les troisièmes segments d'enroulements, de sorte qu'ainsi des enroulements de bobine de la bobine sont formés, où au moins les premiers segments d'enroulements sont rapportés par un procédé d'impression en 3D, lequel permet un apport par une technique d'impression de structures conductrices électriques tridimensionnelles, où une cavité (106) est créée dans le substrat, où les premiers segments d'enroulements (136) sont imprimés sur les flancs (112, 114) de la cavité et les deuxièmes segments d'enroulements (138) sont imprimés sur le fond (110) de la cavité par le procédé d'impression en 3D, où le substrat contient des fibres de verre et la cavité est créée dans le substrat par un procédé de traitement par abrasion de copeaux, de sorte que les fibres de verre du substrat qui se trouvent au niveau d'une zone de bordure de la cavité sont sectionnées par le procédé de traitement par abrasion de copeaux lors de la création de la cavité, où le matériau s'étend au moins sur le fond et les flancs de la cavité, et où le matériau (149) est au moins partiellement retiré à l'extérieur de la cavité, à l'exception d'une couche (151) de matériau qui s'étend par-dessus le fond et les flancs de la cavité, où les premiers segments d'enroulements et les deuxièmes segments d'enroulements sont appliqués sur la couche de matériau.

21. Appareil électronique selon la revendication 20, dans lequel il s'agit d'un capteur et/ou d'un acteur.

22. Appareil électronique selon la revendication 20, dans lequel, dans le cas du capteur, il s'agit d'un capteur de pression, de force, d'accélération ou de champ magnétique.
